# FASCICULE DE BREVET EUROPEEN

(11) **EP 1 248 504 B1**
(45) Date de publication et mention de la délivrance du brevet: **08.06.2005**
(21) Numéro de dépôt: 02352001.8
(22) Date de dépôt: 07.02.2002
(51) Int. Cl.: H05K 5/02, H05K 5/06

(54) **Boitier de communtation électrique étanche**
Abgedichtetes elektrisches Schaltgehäuse
Sealed electrical switching casing

(30) Priorité: 02.03.2001 FR 0102853
(43) Date de publication de la demande: 09.10.2002
(73) Titulaire: Clean Lagun, Urbanizacion de San Jorge de Alfama (ES)
(72) Inventeur: Vogt, Matthias, 24170 Montplaisant (FR)
(74) Mandataire: Morelle, Guy Georges Alain

(56) Documents cités:
- DE-A- 2 914 954
- DE-A- 4 300 521
- US-A- 5 253 143
- US-A- 5 717 574

## Description

La présente invention se rapporte au domaine de la commutation, plus particulièrement aux boîtiers de commutation électrique destinés à permettre la commande d'une connexion électrique entre au moins un premier câble électrique et au moins un deuxième câble électrique, dans des conditions extérieures d'humidité supérieure à la normale, ou d'utilisation en milieu liquide, ou à risque de mouillage.

La commutation électrique fonctionne habituellement en milieu comportant un taux d'humidité voisin ou égal à la normale , et présente un risque de fonctionnement anormal et dangereux dans des conditions d'humidité supérieur à la normale, ou lorsque un liquide est introduit dans le commutateur.

Un objet de la présente invention est de proposer un boîtier de commutation étanche destiné à commander une connexion électrique entre au moins un premier câble électrique et au moins un deuxième câble électrique.

Un autre objet de la présente invention est de proposer un boîtier de commutation étanche destiné à permettre la commande d'une connexion électrique entre au moins un premier câble électrique et une pluralité de câbles électriques.

Un autre objet de la présente invention est de proposer un boîtier de commutation étanche résistant aux chocs, sécurisé, et pratique d'emploi.

Un autre objet de la présente invention est de proposer un boîtier de commutation permettant de limiter l'utilisation des fiches électriques.

Plus précisément, l'invention consiste en un boîtier de commutation électrique destiné à permettre la commande d'une connexion électrique entre au moins un premier câble électrique et au moins un deuxième câble électrique, caractérisé en ce qu'il comprend :
- un carter comportant une paroi rigide étanche aux liquides et définissant un espace libre intérieur,
- au moins une première et une deuxième traversées étanches de paroi, destinées à permettre aux dits au moins premier et deuxième câbles électriques de franchir la paroi étanche du carter, respectivement,
- au moins un premier un deuxième borniers sur lesquels sont fixés lesdits au moins premier et deuxième câbles électriques fil à fil, respectivement,
- au moins un premier commutateur étanche, commandable de l'extérieur du carter et fixé à la paroi de ce dernier, destiné à permettre une connexion électrique entre lesdits premier et deuxième câbles électriques,
- des premiers moyens de liaison électrique entre ledit premier commutateur et ledit premier bornier,
- des deuxièmes moyens de liaison électrique entre ledit premier commutateur et ledit deuxième bornier.

Selon une caractéristique avantageuse, ledit carter comprend une première partie adoptant la forme d'un contenant ouvert et une deuxième partie adoptant une forme complémentaire de l'ouverture de la première partie, lesdites première et deuxième parties étant associées entre elles de manière étanche.

Selon une autre caractéristique avantageuse, ledit boîtier comprend des moyens de fusible à action retardée.

Selon une autre caractéristique avantageuse, lesdits premiers et deuxièmes moyens de liaison électrique entre ledit au moins premier commutateur et lesdits au moins premier et deuxième borniers respectivement, comportent une carte à circuit imprimé sur laquelle sont fixés les premier et deuxième borniers.

Selon une autre caractéristique avantageuse, ledit boîtier comprend au moins un témoin lumineux donnant une information visible de l'extérieur du boîtier de l'état de connexion desdits au moins premier et deuxième câbles électriques.

Selon une autre caractéristique avantageuse, lesdites au moins première et deuxième traversées étanches de paroi comportent respectivement des premier et deuxième moyens de serrage desdits premier et deuxième câbles, dans une plage de diamètres déterminée.

Selon une autre caractéristique avantageuse, les moyens de serrage comprennent respectivement une pluralité de languettes apte à entourer un câble, lesdites languettes comportant des extrémités libres aptes à converger vers l'axe du câble sous l'effet d'une poussée parallèle au dit axe de câble en vue d'assurer un serrage dudit câble.

Selon une autre caractéristique avantageuse, ladite poussée parallèle au dit axe de câble est assurée par un système vis-écrou.

Selon une autre caractéristique avantageuse, lesdites languettes sont régulièrement réparties sur une surface annulaire destinée à entourer le câble, lesdites languettes comportant respectivement une section transversale d'épaisseur décroissante vers l'intérieur de la surface annulaire.

Selon une autre caractéristique avantageuse, le boîtier selon l'invention est destiné à permettre en outre la commande d'une connexion électrique entre ledit premier câble électrique et un troisième, quatrième, et cinquième câbles électriques, et comprend en outre:
- une troisième, quatrième, et cinquième traversées étanches de paroi destinées à permettre à des troisième, quatrième, et cinquième câbles électriques de franchir la paroi étanche du carter, respectivement,
- un troisième, quatrième, et cinquième borniers sur lesquels sont fixés les troisième, quatrième, et cinquième câbles électriques fil à fil, respectivement,
- un deuxième, troisième, et quatrième commutateurs étanches, commandables de l'extérieur du carter et fixés à la paroi de ce dernier, destinés à commander une connexion électrique entre lesdits premier et troisième, premier et quatrième, premier et cinquième câbles électriques, respectivement,
- des troisième, quatrième, et cinquième moyens de liaison électrique entre lesdits deuxième, troisième, et quatrième commutateurs et ledit premier bornier, respectivement,
- des sixième, septième, et huitième moyens de liaison électrique entre lesdits deuxième, troisième, et quatrième commutateurs et lesdits troisième, quatrième, et cinquième borniers, respectivement.

D'autres caractéristiques et avantages apparaîtront à la lecture qui suit de la description d'un exemple de mode de réalisation d'un boîtier de commutation étanche selon l'invention, accompagnée des dessins annexés, exemple donné à titre illustratif non limitatif.
La figure 1 représente une vue schématique de dessus, en coupe partielle, d'un exemple de mode de réalisation d'un boîtier de commutation étanche selon l'invention.
La figure 2 représente une vue schématique en coupe longitudinale suivant la ligne I-I de l'exemple représenté sur la figure 1.
La figure 3 représente une vue schématique en coupe transversale partielle suivant la ligne II-II de la figure 1, de l'exemple représenté.
La figure 4 représente une vue en perspective de l'exemple représenté sur la figure 1.
La figure 5 représente une vue agrandie en coupe longitudinale d'un détail de l'exemple selon la figure 1.
La figure 6 représente une vue en coupe selon la ligne III-III de la figure 5.
La figure 7 représente une vue de dessus de la carte à circuit imprimé munie des composants équipant le boîtier représenté sur la figure 1
La figure 8 représente en vue de dessus un schéma du circuit électrique imprimé de la carte à circuit imprimé représenté sur la figure 7.

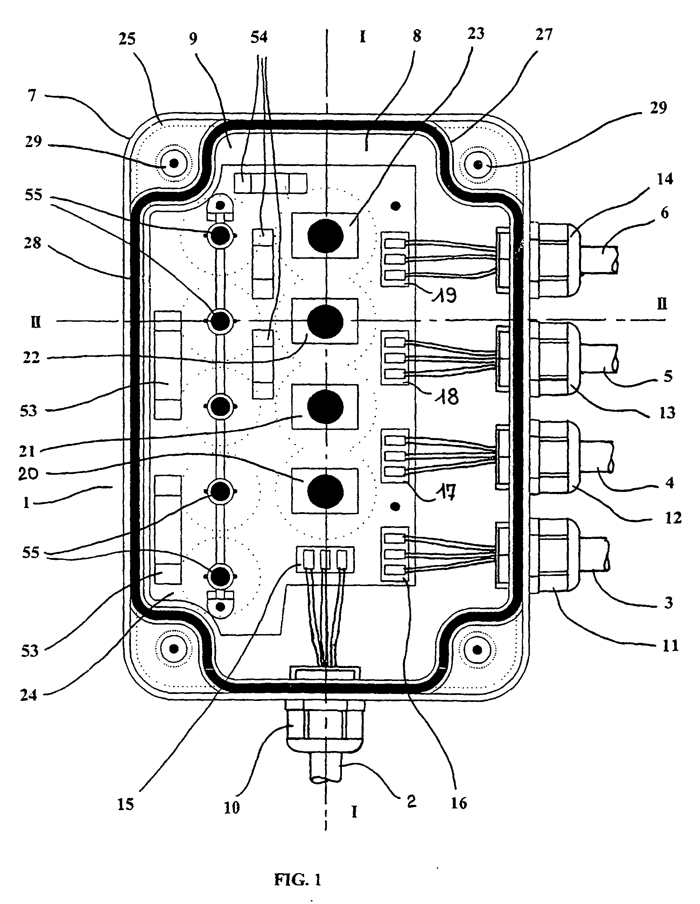

Le boîtier 1 de commutation électrique étanche représenté sur la figure 1 est destiné à permettre la commande d'une connexion électrique entre un premier câble 2 électrique d'une part et un deuxième 3, troisième 4, quatrième 5, et/ou cinquième 6 câbles électriques d'autre part. Afin de réaliser cet objectif, le boîtier 1 comprend :
- un carter 7 comportant une paroi 8 rigide étanche aux liquides et définissant un espace libre 9 intérieur,
- une première 10, deuxième 11, troisième 12, quatrième 13, et cinquième 14 traversées étanches de paroi destinées à permettre aux premier 2, deuxième 3, troisième 4, quatrième 5, et cinquième 6 câbles électriques de franchir la paroi 8 étanche du carter 7, respectivement,
- un premier 15, deuxième 16, troisième 17, quatrième 18, et cinquième 19 borniers sur lesquels sont fixés les premier 2, deuxième 3, troisième 4, quatrième 5, et cinquième 6 câbles électriques fil à fil, respectivement, comme représenté sur la figure 1,
- un premier 20, deuxième 21, troisième 22, quatrième 23 commutateurs étanches, commandables de l'extérieur du carter 7 et fixés à la paroi 8 de ce dernier, destiné à permettre une connexion électrique respectivement entre les premier 2 et deuxième 3 câbles électriques, entre les premier 2 et troisième 4 câbles électriques, entre les premier 2 et quatrième 5 câbles électriques, entre les premier 2 et cinquième 6 câbles électriques,
- des moyens 24 de liaison électrique, respectivement :
   - entre le premier 20 commutateur et le premier bornier 15 d'une part, et entre le premier 20 commutateur et le deuxième 16 bornier,
   - entre le deuxième 21 commutateur et le premier bornier 15 d'une part, et entre le deuxième 21 commutateur et le troisième 17 bornier,
   - entre le troisième 22 commutateur et le premier bornier 15 d'une part, et entre le troisième 22 commutateur et le quatrième 18 bornier,
   - entre le quatrième 23 commutateur et le premier bornier 15 d'une part, et entre le quatrième 23 commutateur et le cinquième 19 bornier.

Le carter 7 comprend avantageusement une première partie 25 adoptant la forme d'un contenant ouvert, par exemple un parallélépipède rectangle, et une deuxième partie 26 adoptant une forme complémentaire de l'ouverture 27 de la première partie 25, les première 25 et deuxième 26 parties étant associées entre elles de manière étanche, grâce à un joint d'étanchéité 28 placé entre la première partie et la deuxième partie le long des surfaces de contact entre ces deux parties, comme représenté sur les figures 1 à 3.

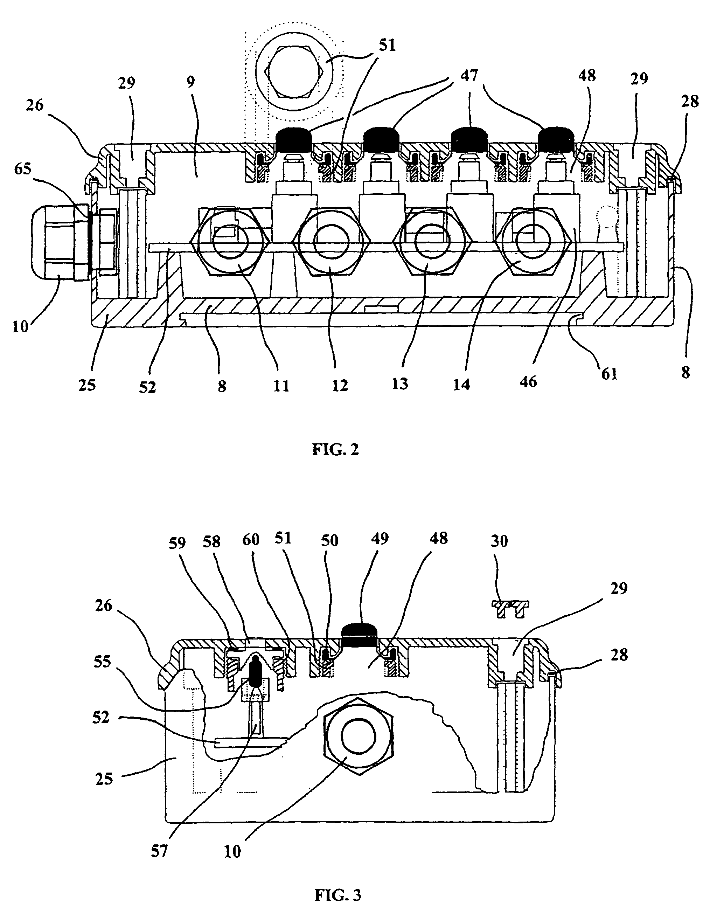

Sur la figure 1, la deuxième partie 26 a été retirée de manière à montrer l'intérieur de la première partie 25. La deuxième partie 26 du carter 7 sera fixée de manière démontable sur la première partie 25 du carter par l'intermédiaire de vis inoxydables (non représentées), de préférence quatre vis encastrées dans des logements 29 prévus à cet effet, comme représenté sur les figures 1 à 3. Il est à noter que sur les figures 2 et 3, les logements de vis ont été totalement ou partiellement ramenés dans le plan de coupe afin que ces logements soient représentés. Les liaisons par vis des deux parties 25, 26 du carter 7 seront, soit rendues étanches, soit réalisées de manière à ce qu'elles ne débouchent pas dans l'espace 9 à l'intérieur du carter. Un capuchon 30 peut venir obturer le logement 29 permettant l'encastrement d'une vis, par exemple comme représenté sur la figure 3 où le capuchon est montré à l'extérieur du logement.

Le carter 7 peut être constitué de tout matériau étanche, de préférence électriquement non conducteur, inoxydable, ininflammable, et résistant aux chocs, par exemple une matière plastique appropriée. Un Acrylonitrile-butadiène styrène (ABS) peut être avantageusement choisi à cet effet. En outre, le carter 7 peut être pourvu de tous moyens permettant de le fixer sur un support quelconque, par exemple mural; ces moyens peuvent être une rainure 61 dans laquelle s'engagerait à coulissement une plaque de fixation (non représentée) elle-même fixée au dit support.

Les première 10, deuxième 11, troisième 12, quatrième 13, et cinquième 14 traversées étanches de paroi sont fixées sur les parois latérales du carter 7, la première sur un petit côté et les autres sur un grand côté, comme représenté sur la figure 1. Les cinq traversées étanches 10, 11, 12, 13, et 14 sont identiques, réalisées de préférence en matière plastique comme expliqué plus loin et fixées par un système vis-écrou dans des trous respectifs du carter prévus à cet effet, par l'intermédiaire d'un joint d'étanchéité 65 intercalé entre chaque traversée et la paroi du carter. Une traversée 10, 11, 12, 13, 14 comprend un corps 37 cylindrique percé d'un trou 38 axial pour le passage du câble. Le corps 37 cylindrique est muni sur sa surface extérieure d'un moyen de prise 39 adoptant la forme d'une collerette pour une clé de serrage, et d'un écrou 40 vissé à une extrémité du corps afin de permettre sa fixation sur la paroi 8 du carter 7, serré entre les moyens de prise 39 et l'écrou 40 et le joint d'étanchéité 65. L'écrou 40 est placé à l'intérieur du carter 7. A l'autre extrémité du corps se trouve une surface annulaire de bout 35 munie de moyens de serrage 31 du câble qui la traverse, dans une plage de diamètres déterminée afin de conférer au boîtier de commutation une souplesse d'utilisation en permettant à une traversée un serrage de câbles électriques ayant des diamètres différents.

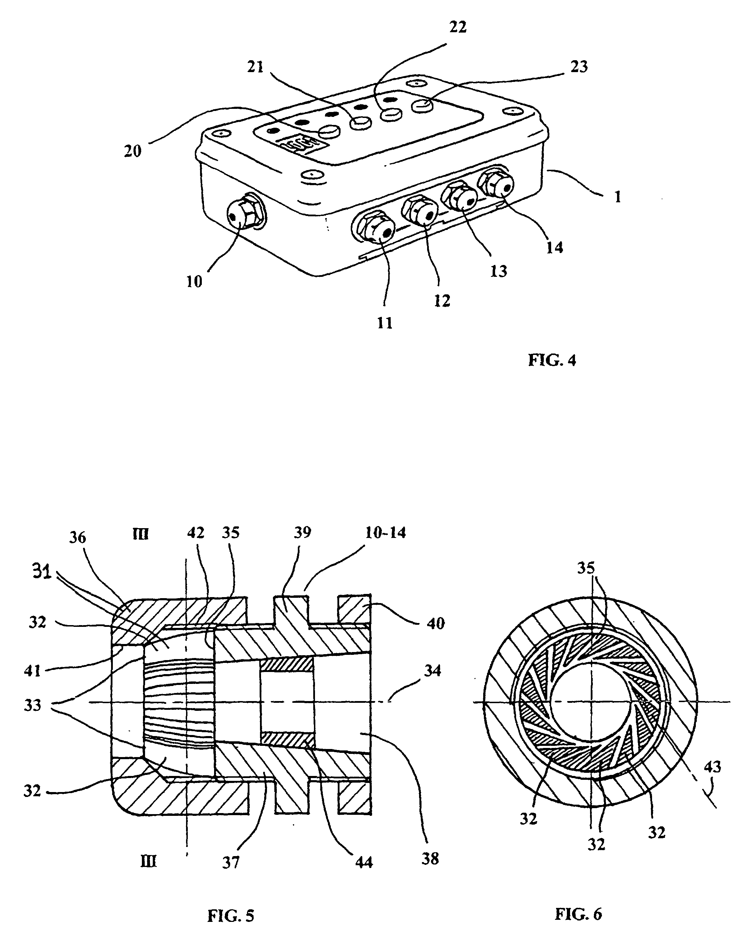

Comme représenté sur la figure 5, les moyens de serrage 31 d'une traversée 10, 11, 12, 13, ou 14 comprennent respectivement une pluralité de languettes 32 apte à entourer un câble symbolisé sur la figure 5 par son axe 34 longitudinal confondu avec l'axe du corps de la traversée, les languettes 32 présentant une souplesse suffisante, et comportant des extrémités libres 33 aptes à converger vers l'axe 34 du câble sous l'effet d'une poussée parallèle à cet axe 34 en vue d'assurer un serrage du câble. La base des languettes est liée à la surface annulaire 35 du corps de traversée.

Comme représenté sur la figure 6, les languettes 32 sont régulièrement réparties sur la surface annulaire 35, cette dernière étant de préférence perpendiculaire à l'axe 34, destinée à entourer le câble, et constituée par la surface d'extrémité du corps 37 de la traversée, les languettes 32 comportant respectivement une section transversale d'épaisseur décroissante vers l'intérieur de la surface annulaire 35 et sensiblement constante selon l'axe longitudinal 34. Les languettes 32 sont réalisées parallèlement à l'axe 34 et restent telles quelles à l'état de repos, et leurs extrémités libres 33 respectives doivent pouvoir converger vers l'axe 34 du câble sous la poussée d'un écrou 36 de serrage en prise sur le corps 37 de la traversée grâce au déplacement axial de l'écrou. A cet effet, l'écrou 36 comporte à une extrémité un diamètre de passage supérieur au diamètre du câble le plus grand que l'on souhaite utiliser, et inférieur au diamètre extérieur déterminé par les languettes 32 de façon à contraindre les languettes à converger vers l'axe 34 lorsque l'écrou 36 est serré. Lorsque l'écrou 36 est desserré, les languettes 32 pourront soit reprendre leur position initiale de repos si le matériau dans lequel elles sont réalisées est suffisamment élastique, soit rester en place et s'écarter sous une traction du câble que l'on souhaiterait retirer. L'écrou 36 pourra comporter à l'intérieur une surface conique développée entre le trou 41 de dégagement du câble et le taraudage 42 de mise en prise sur le corps 37, visant à aider le guidage de la déformation des languettes 32, comme représenté sur la figure 5.

Comme représenté sur la figure 6, l'axe transversal 43 respectif des languettes, qui traverse la surface annulaire, est orienté sensiblement selon une corde de la surface annulaire; ainsi, l'orientation de cet axe 43 qui définit la direction de la déformation la plus facile de la languette 32, doit être telle que cette dernière sera naturellement apte à être déformée vers l'axe 34 afin de pouvoir exercer une pression sur le câble. La structure décrite précédemment, et telle que représentée sur les figures 5 et 6, des languettes 32 permet lors d'un rapprochement de celles-ci vers l'axe 34 sous l'effet de l'écrou 36, de réduire le diamètre de serrage défini par les extrémités 33 des languettes 32 de manière concentrique à l'axe 34, par glissement des extrémités 33 les unes sur les autres, et permettre ainsi un serrage de câbles de divers diamètres, par exemple des câbles de 4 à 8 mm de diamètre. Lorsque les languettes se rapprochent de l'axe 34 sous l'effet de la poussée de l'écrou 36, l'inclinaison de l'axe transversal 43 incite ces languettes à se déformer tout en étant imbriquées les unes dans les autres vers leurs extrémités 33, conférant à l'ensemble des languettes une bonne rigidité en vue d'un serrage correct du câble.

Le trou 38 de passage du câble dans le corps 37 de la traversée sera de préférence légèrement conique, le grand diamètre du cône étant placé vers l'intérieur du carter et le petit diamètre vers l'extérieur, le petit diamètre du cône étant supérieur au plus grand diamètre de câble à serrer. A l'intérieur du trou 38, sera placée une bague d'étanchéité 44 cylindrique de section transversale circulaire constante, réalisée en matière élastique, afin de faire étanchéité entre la surface extérieure du câble et la surface intérieure du trou 38. Selon le diamètre de câble à serrer, la bague pourra être déplacée le long du trou conique afin de trouver l'emplacement appropriée pour une étanchéité correcte.

De préférence, la traversée sera réalisée dans une matière plastique rigide mais non cassante, monobloc, la souplesse des languettes 32 étant conférée par leur longueur respective importante devant les dimensions de la section transversale. Les écrous 40 et 36 de la traversée seront rapportés par vissage et réalisés dans le même matériau que le corps 37 de traversée.

Les borniers 15, 16, 17, 18, 19 sont identiques et de tous types connus, et comportent chacun trois plots de serrage isolés afin de permettre la fixation d'un câble à trois fils conducteurs et la connexion de ces derniers, la phase, le neutre et la terre, par exemple pour un usage dans les habitations, commerces et bureaux du boîtier de commutation selon l'invention. Les borniers peuvent être des borniers à vis, et comporter chacun autant de plots de connexion qu'il y a de fils dans un câble à connecter.

Les commutateurs étanches 20, 21, 22, et 23 sont identiques, et tout type de commutateurs étanches connus peut être utilisé. De préférence, un commutateur étanche comprend un commutateur conventionnel 46, de type poussoir, fixé à l'intérieur du carter 7, et un capuchon 47 étanche fixé à la paroi du carter 7, permettant à un opérateur d'actionner le bouton poussoir 46 à partir de l'extérieur du boîtier pour établir une connexion entre les câbles électriques connectés à ce bouton poussoir. Comme représenté sur les figures 2 et 3, le capuchon 47 est constitué d'une enveloppe souple étanche comportant une partie creuse 49 destinée à recevoir le bouton poussoir 46, entourée d'une collerette 50 destinée à permettre une fixation du capuchon 47 dans un logement 48 prévu à cet effet sur la paroi du carter, plus précisément de la deuxième partie 26 du carter. Le capuchon 47 est fixé de manière étanche sur le carter 7 grâce à un écrou 51 comprimant la collerette contre le carter. La partie creuse 49 traverse une ouverture du carter prévue à cet effet, dans l'axe de laquelle se trouve le bouton poussoir 46. Le matériau constitutif du capuchon 47 sera de préférence un caoutchouc synthétique, par exemple un silicone contenant en tant que composant principal un squelette silicone-oxygène, conférant au capuchon une haute élasticité, une bonne résistance à des températures de fonctionnement basses et hautes, notamment -60° C à 250°C, pour un coût de revient économique.

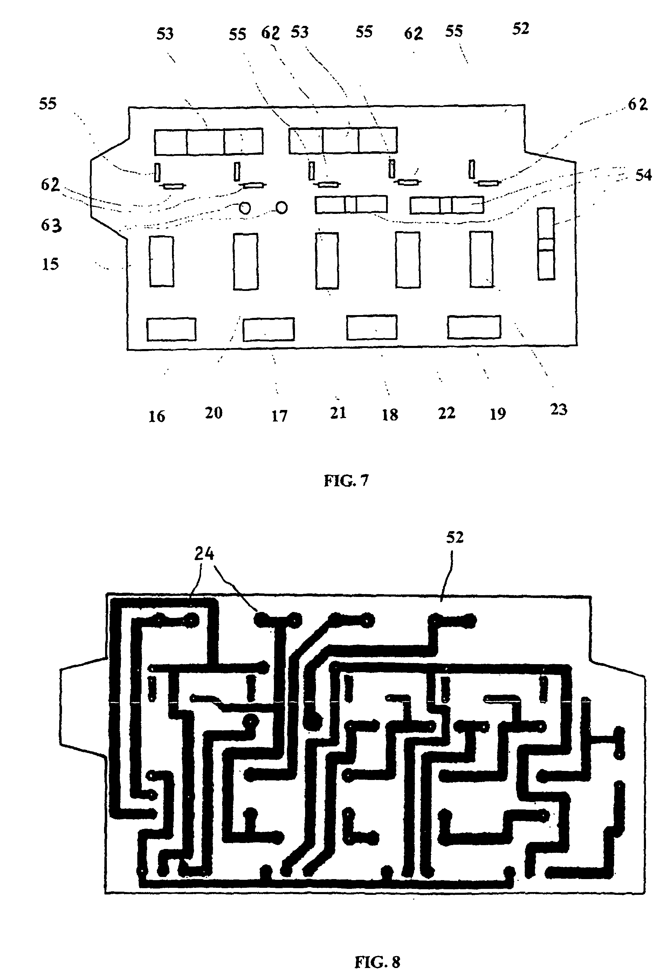

Les moyens de liaison électrique entre les commutateurs et les borniers comme décrit précédemment peuvent être avantageusement constitués par des circuits 24 appropriés de toutes manières connues, réalisés sur une carte 52 à circuit imprimé comme représenté sur la figure 8 par exemple, carte 52 qui servira de support à tous les composants électriques du boîtier, soit les borniers, les commutateurs et autres composants comme décrit plus loin. A cet effet, ces composants seront choisis de manière à être implantables sur un circuit imprimé. La carte 52 à circuit imprimé sera fixée rigidement à l'intérieur du carter sur la première partie 25 de celui-ci, aux moyens de vis (non représentées).

De préférence les liaisons électriques seront protégées contre les courts-circuits aux moyens de plusieurs fusibles 53 et 54, dimensionnés selon la tension et l'intensité maximales admissibles sur le circuit considéré. On peut par exemple envisager, dans le cas d'une alimentation en 220 Volts sur le premier câble, un fusible de 10 ampères sur ce dernier, et sur les sorties séparées (autres câbles électriques) des fusibles de 2,5 ampères par exemple, respectivement. De préférence, des fusibles à action retardée seront utilisés.

Comme représenté sur les figures 1 et 3, le boîtier de commutation étanche comprend avantageusement des témoins lumineux 55 donnant une information visible de l'extérieur du boîtier, de l'état de connexion des câbles électriques, c'est à dire de la position de chaque commutateur. A cet effet, le boîtier comprend un témoin lumineux par commutateur, soit quatre dans l'exemple représenté. Les témoins lumineux seront implantés sur le circuit imprimé, éventuellement par l'intermédiaire d'une rampe support protectrice 57 fixée par exemple à la carte 52 à circuit imprimé, comme représenté sur la figure 3. Cette rampe 57 permet une séparation physique entre les fils conducteurs des témoins lumineux afin d'améliorer la protection contre les courts-circuits. Afin que les témoins lumineux soient visibles de l'extérieur du boîtier, des ouvertures seront réalisées et obturées de manière étanche par un hublot 58 respectivement, laissant passer la ou les longueurs d'ondes lumineuses voulues. Les hublots 58 seront de forme similaire et de couleurs différentes ou non. De préférence, les témoins lumineux sont identiques et seront éventuellement différenciés par leur couleur respective. Comme pour les capuchons des commutateurs, les hublots seront respectivement fixés par un écrou 60, avec en outre un joint d'étanchéité 59 placé entre chaque hublot et le carter, ou plus précisément entre chaque hublot et la première partie 25 du carter.

Les figures 7 et 8 montrent à titre d'exemple, une implantation des divers composants qui ont été décrits plus haut, sur la carte 52 à circuit imprimé et leurs liaisons électriques, respectivement. Les liaisons électriques sont représentées en trait noir sur la figure 8, et ont été représentées sur le même côté de la carte que les composants représentés de la figure 7, afin de faciliter la lecture des circuits, et la correspondance avec les liaisons électriques. Sur la figure 7, la carte comprend des résistances 62 calculées en accord avec les caractéristiques électriques des témoins lumineux 55, le cas échéant. Les références 63 déterminent les bornes d'un pont électrique sur la carte. Il est à noter que les échelles de représentation des figures 7 et 8 sont différentes et que ces figures sont de simples représentations schématiques. Des écarts dimensionnels peuvent exister entre les deux représentations, ne gênant pas la compréhension des figures pour l'homme de l'art.

## Revendications

1. Boîtier (1) de commutation électrique destiné à permettre la commande d'une connexion électrique entre au moins un premier (2) câble électrique et au moins un deuxième (3) câble électrique, ***caractérisé en ce qu*'**il comprend :
- un carter (7) comportant une paroi (8) rigide étanche aux liquides et définissant un espace libre intérieur (9),
- au moins une première (10) et une deuxième (11) traversées étanches de paroi destinées à permettre aux dits au moins premier et deuxième câbles électriques de franchir la paroi étanche du carter, respectivement,
- au moins un premier (15) un deuxième (16) borniers sur lesquels sont fixés lesdits au moins premier et deuxième câbles électriques fil à fil, respectivement,
- au moins un premier (20) commutateur étanche, commandable de l'extérieur du carter (7) et fixé à la paroi de ce dernier, destiné à permettre une connexion électrique entre lesdits premier et deuxième câbles électriques,
- des premiers moyens de liaison électrique entre ledit premier (20) commutateur et ledit premier (15) bornier,
- des deuxièmes moyens de liaison électrique entre ledit premier (20) commutateur et ledit deuxième (16) bornier.

2. Boîtier selon la revendication 1, ***caractérisé en ce que*** ledit carter (7) comprend une première (25) partie adoptant la forme d'un contenant ouvert et une deuxième (26) partie adoptant une forme complémentaire de l'ouverture (27) de la première partie, lesdites première et deuxième parties étant associées entre elles de manière étanche.

3. Boîtier selon la revendication 1 ou 2, ***caractérisé en ce qu***'il comprend des moyens de fusible (54) à action retardée.

4. Boîtier selon l'une des revendications 1 à 3, ***caractérisé en ce que*** lesdits premiers et deuxièmes moyens de liaison électrique entre ledit au moins premier (20) commutateur et lesdits au moins premier (15) et deuxième (16) borniers respectivement, comportent une carte (52) à circuit imprimé (24) sur laquelle sont fixés les premier et deuxième bomicrs.

5. Boîtier selon l'une des revendications 1 à 4, ***caractérisé en ce qu***'il comprend au moins un témoin lumineux (55) donnant une information visible de l'extérieur du boîtier de l'état de connexion desdits au moins premier (2) et deuxième (3) câbles électriques.

6. Boîtier selon l'une des revendications 1 à 5, ***caractérisé en ce que*** lesdites au moins première (10) et deuxième (11) traversées étanches de paroi comportent respectivement des premier et deuxième moyens (32) de serrage desdits premier (2) et deuxième (3) câbles, dans une plage de diamètres déterminée.

7. Boîtier selon la revendication 6, ***caractérisé en ce que*** les moyens de serrage comprennent respectivement une pluralité de languettes (32) apte à entourer un câble, lesdites languettes comportant des extrémités (33) libres aptes à converger vers l'axe (34) du câble sous l'effet d'une poussée parallèle au dit axe de câble en vue d'assurer un serrage dudit câble.

8. Boîtier selon la revendication 7, ***caractérisé en ce que*** ladite poussée parallèle au dit axe de câble est assurée par un système vis-écrou (42).

9. Boîtier selon la revendication 7 ou *8,* ***caractérisé en ce que*** lesdites languettes (32) sont régulièrement réparties sur une surface annulaire (35) destinée à entourer le câble, lesdites languettes comportant respectivement une section transversale d'épaisseur décroissante vers l'intérieur de la surface annulaire.

10. Boîtier selon l'une des revendications 1 à 9, ***caractérisé en ce qu*'**il est destiné à permettre en outre la commande d'une connexion électrique entre ledit premier (2) câble électrique et un troisième (4), quatrième (5), et cinquième (6) câbles électriques, et en ce qu'il comprend en outre :
- une troisième (12), quatrième (13), et cinquième (14) traversées étanches de paroi destinées à permettre aux troisième (4), quatrième (5), et cinquième (6) câbles électriques de franchir la paroi (8) étanche du carter, respectivement,
- un troisième (17), quatrième (18), et cinquième (19) borniers sur lesquels sont fixés les troisième, quatrième, et cinquième câbles électriques fil à fil, respectivement,
- un deuxième (21), troisième (22), et quatrième (23) commutateurs étanches, commandables de l'extérieur du carter et fixés à la paroi de ce dernier, destinés à permettre une connexion électrique entre lesdits premier (2) et troisième (4), premier (2) et quatrième (5), premier (2) et cinquième (6) câbles électriques, respectivement,
- des troisième, quatrième, et cinquième moyens de liaison électrique entre lesdits deuxième, troisième, et quatrième commutateurs et ledit premier bornier, respectivement,
- des sixième, septième, et huitième moyens de liaison électrique entre lesdits deuxième, troisième, et quatrième commutateurs et lesdits troisième, quatrième, et cinquième borniers, respectivement.

## Patentansprüche

1. Elektrischer Schaltkasten (1), der dazu bestimmt ist, die Steuerung einer elektrischen Verbindung zwischen mindestens einem ersten Elektrokabel (2) und mindestens einem zweiten Elektrokabel (3) zu ermöglichen, **dadurch gekennzeichnet, dass** er aufweist:
- ein Gehäuse (7) mit einer steifen, flüssigkeitsdichten Wand (8), das einen freien Innenraum (9) definiert,
- mindestens eine erste (10) und eine zweite dichte Wanddurchführung (11), die dazu bestimmt sind, dem ersten bzw. dem zweiten Elektrokabel den Durchtritt durch die dichte Wand des Gehäuses zu ermöglichen,
- mindestens eine erste (15) und eine zweite Klemmenleiste (16), an denen das erste bzw. das zweite Elektrokabel Draht für Draht befestigt sind,
- mindestens einen ersten dichten Schalter (20), der von außerhalb des Gehäuses (7) steuerbar und an dessen Wand befestigt ist, dazu bestimmt, eine elektrische Verbindung zwischen dem ersten und dem zweiten Elektrokabel zu ermöglichen,
- erste elektrische Verbindungsmittel zwischen dem ersten Schalter (20) und der ersten Klemmenleiste (15),
- zweite elektrische Verbindungsmittel zwischen dem ersten Schalter (20) und der zweiten Klemmenleiste (16).

2. Kasten nach Anspruch 1, **dadurch gekennzeichnet, dass** das Gehäuse (7) einen ersten Teil (25), der die Form eines offenen Behälters hat, und einen zweiten Teil (26) aufweist, der eine zur Öffnung (27) des ersten Teils komplementäre Form hat, wobei der erste und der zweite Teil dicht zusammenpassen.

3. Kasten nach Anspruch 1 oder 2, **dadurch gekennzeichnet, dass** er Schmelzsicherungseinrichtungen (54) mit verzögerter Wirkung aufweist.

4. Kasten nach einem der Ansprüche 1 bis 3, **dadurch gekennzeichnet, dass** die ersten und zweiten Mittel zur elektrischen Verbindung zwischen dem mindestens ersten Schalter (20) und der mindestens ersten (15) bzw. zweiten Klemmenleiste (16) eine Karte (52) mit gedruckter Schaltung (24) aufweisen, auf der die erste und die zweite Klemmenleiste befestigt sind.

5. Kasten nach einem der Ansprüche 1 bis 4, **dadurch gekennzeichnet, dass** er mindestens eine Leuchtanzeige (55) aufweist, die eine von außerhalb des Kastens sichtbare Information über den Verbindungszustand der mindestens ersten (2) und zweiten Elektrokabel (3) anzeigt.

6. Kasten nach einem der Ansprüche 1 bis 5, **dadurch gekennzeichnet, dass** die mindestens erste (10) und zweite dichte Wanddurchführung (11) erste bzw. zweite Einrichtungen (32) zum Einklemmen des ersten (2) bzw. zweiten Kabels (3) in einem bestimmten Durchmesserbereich aufweisen.

7. Kasten nach Anspruch 6, **dadurch gekennzeichnet, dass** die Klemmeinrichtungen je mehrere Zungen (32) aufweisen, die fähig sind, ein Kabel zu umgeben, wobei die Zungen freie Enden (33) besitzen, die geeignet sind, unter der Wirkung eines Schubs parallel zur Kabelachse zur Achse (34) des Kabels zu konvergieren, um das Einklemmen des Kabels zu gewährleisten.

8. Kasten nach Anspruch 7, **dadurch gekennzeichnet, dass** der Schub parallel zur Kabelachse durch ein Schraube-Mutter-System (42) gewährleistet wird.

9. Kasten nach Anspruch 7 oder 8, **dadurch gekennzeichnet, dass** die Zungen (32) regelmäßig auf einer Ringfläche (35) verteilt sind, die das Kabel umgeben soll, wobei die Zungen je einen Querschnitt aufweisen, dessen Dicke zum Inneren der Ringfläche hin abnimmt.

10. Kasten nach einem der Ansprüche 1 bis 9, **dadurch gekennzeichnet, dass** er dazu bestimmt ist, außerdem die Steuerung einer elektrischen Verbindung zwischen dem ersten Elektrokabel (2) und einem dritten (4), vierten (5) und fünften Elektrokabel (6) zu ermöglichen, und dass er weiter aufweist:
- eine dritte (12), vierte (13), und fünfte dichte Wanddurchführung (14), die dazu bestimmt sind, dem dritten (4), vierten (5) und fünften Elektrokabel (6) den Durchtritt durch die dichte Wand (8) des Gehäuses zu ermöglichen,
- eine dritte (17), vierte (18) und fünfte Klemmenleiste (19), an denen das dritte, vierte bzw. fünfte Elektrokabel Draht für Draht befestigt sind,
- einen zweiten (21), dritten (22) und vierten dichten Schalter (23), die von außerhalb des Gehäuses (7) steuerbar und an dessen Wand befestigt sind, dazu bestimmt, eine elektrische Verbindung zwischen dem ersten (2) und dem dritten (4), bzw. dem ersten (2) und dem vierten (5), bzw. dem ersten (2) und dem fünften Elektrokabel (6) zu ermöglichen,
- dritte, vierte und fünfte Mittel zur elektrischen Verbindung zwischen dem zweiten, dritten bzw. vierten Schalter und der ersten Klemmenleiste,
- sechste, siebte und achte Mittel zur elektrischen Verbindung zwischen dem zweiten, dritten und vierten Schalter und der dritten, vierten bzw. fünften Klemmenleiste.

## Claims

1. Electrical commutation box (1) which is intended to allow control of an electrical connection between at least a first electrical cable (2) and at least a second electrical cable (3), ***characterised in that*** it comprises:
- a casing (7) including a rigid wall (8) which is impermeable to liquids and defines a free interior space (9),
- at least a first (10) and a second (11) sealed wall passages which are intended to allow said at least first and second electrical cables to traverse the sealed casing wall respectively,
- at least a first (15) and a second (16) terminals on which there are fixed said at least first and second electrical cables wire to wire respectively,
- at least a first sealed commutator (20), which can be controlled from the exterior of the casing (7) and is fixed on the wall of the latter, intended to allow an electrical connection between said first and second electrical cables,
- first electrical connection means between said first commutator (20) and said first terminal (15),
- second electrical connection means between said first commutator (20) and said second terminal (16).

2. Box according to claim 1, ***characterised in that*** said casing (7) comprises a first part (25) which adopts the form of an open container and a second part (26) which adopts a form complementary to the opening (27) of the first part, said first and second parts being associated with each other in a sealed manner.

3. Box according to claim 1 or 2, ***characterised in that*** it comprises delayed action fuse means (54).

4. Box according to one of the claims 1 to 3, ***characterised in that*** said first and second electrical connection means between said at least first commutator (20) and said at least first (15) and second (16) terminals respectively include a board (52) with a printed circuit (24) on which the first and second terminals are fixed.

5. Box according to one of the claims 1 to 4, ***characterised in that*** it comprises at least one indicator lamp (55) which gives information which is visible from the exterior of the box about the connection state of said at least first (2) and second (3) electrical cables.

6. Box according to one of the claims 1 to 5, ***characterised in that*** said at least first (10) and second (11) sealed wall passages include respectively first and second clamping means (32) of said first (2) and second (3) cables, in a determined range of diameters.

7. Box according to claim 6, ***characterised in that*** the clamping means comprise respectively a plurality of tongues (32) which are able to surround a cable, said tongues including free ends (33) which are able to converge towards the axis (34) of the cable under the effect of a thrust parallel to said cable axis with the aim of ensuring clamping of said cable.

8. Box according to claim 7, ***characterised in that*** said thrust parallel to said cable axis is ensured by a screw-nut system (42).

9. Box according to claim 7 or 8, ***characterised in that*** said tongues (32) are distributed regularly over an annular surface (35) which is intended to surround the cable, said tongues including respectively a transverse section with a thickness which decreases towards the interior of the annular surface.

10. Box according to one of the claims 1 to 9, ***characterised in that*** it is intended to allow furthermore control of an electrical connection between said first electrical cable (2) and a third (4), fourth (5) and fifth (6) electrical cables and **in that** it comprises furthermore:
- a third (12), fourth (13) and fifth (14) sealed wall passages which are intended to allow the third (4), fourth (5) and fifth (6) electrical cables to traverse the sealed casing wall (8) respectively,
- a third (17), fourth (18) and fifth (19) terminals on which there are fixed the third, fourth and fifth electrical cables wire to wire respectively,
- a second (21), third (22) and fourth (23) sealed commutators (20), which can be controlled from the exterior of the casing and are fixed on the wall of the latter, intended to allow an electrical connection between said first (2) and third (4), first (2) and fourth (5), first (2) and fifth (6) electrical cables respectively.
- third, fourth and fifth electrical connection means between said second, third and fourth commutators and said first terminal respectively.
- sixth, seventh and eighth electrical connection means between said second, third and fourth commutators and said third, fourth and fifth terminals respectively.
